# EUROPÄISCHE PATENTANMELDUNG

(11) **EP 0 623 952 A1**
(43) Veröffentlichungstag der Anmeldung: **09.11.1994**
(21) Anmeldenummer: 94810211.6
(22) Anmeldetag: 14.04.1994
(51) Int. Cl.: H01L 23/367, H01L 23/467

(54) **Kühlkörper für Halbleiterbauelemente**

(30) Priorität: 04.05.1993 DE 4314663
(71) Anmelder: ALUSUISSE-LONZA SERVICES AG, CH-8034 Zürich (CH)
(72) Erfinder: Bock, Uwe, D-78221 Singen (DE)

(57) **Zusammenfassung**

Kühlkörper (10) für Halbleiterbauelemente oder dgl. Bauteil, insbesondere aus stranggepresstem Leichtmetall, mit in Abstand etwa parallel zueinander von einer Grundplatte (12) aufragenden Kühlrippen (20) etwa stabartigen Querschnittes, wobei die Grundplatte an einer Oberfläche (14) Haltenuten (16) aufweist, in welchen jeweils eine Kühlrippe mit einem Sockelabschnitt festgelegt ist. In die Kühlrippen sind jeweils mehrere Durchbrüche (26) eingeformt und die Flächen des zwischen zwei Stegen verlaufenden Durchbruches etwas geringer ist als der durch den lichten Rippenabstand vorgegebene Strömungsquerschnitt zwischen zwei benachbarten Kühlrippen.

## Beschreibung

Die Erfindung betrifft einen Kühlkörper für Halbleiterbauelemente od.dgl. Bauteile, insbesondere aus stranggepreßtem Leichtmetall, mit in Abstand etwa parallel zueinander von einer Grundplatte aufragenden Kühlrippen etwa stabartigen Querschnittes, wobei die Grundplatte an einer Oberfläche Haltenuten aufweist, in welchen jeweils eine Kühlrippe mit einem Sockelabschnitt festgelegt ist.

Bei einem in der DE-PS 25 02 472 beschriebenen Kühlkörper sind aus den Wänden der Haltenuten der Grundplatte in Längsrichtung Wandrippen herausgepreßt. In die Haltenuten werden Kühlrippen mit vertikaler Riffelung eingepreßt und zwar auf dem Wege des Kaltpreßschweißens. Durch die beim Kaltpreßschweißvorgang erforderlichen hohen Kräfte bleibt die Länge der entstehenden Kühlkörper stark begrenzt, auch ist eine Mindestdicke der Kühlrippen erforderlich, um deren Abknicken beim Kaltpreßschweißen zu vermeiden.

Die DE-PS 35 18 310 offenbart einen Kühlkörper mit hohem Rippenverhältnis, das sehr geringe Rippenabstände ermöglicht. Zwar besteht hier eine verhältnismäßig große wärmeabführende Oberfläche, jedoch führt der enge Rippenabstand -- verbunden mit geringer Luftgeschwindigkeit -- oftmals zu einer Laminarströmung mit entsprechend niedrigem Wärmeübergangskoeffizienten. Damit sind einer optimalen Nutzung aus strömungstechnischen Gründen Grenzen gesetzt. Zudem ist die Anströmrichtung bzw. die Ansaugrichtung in Längsrichtung vorgegeben, d.h. eine Anströmung quer oder diagonal bleibt von sehr geringem Effekt. Bei einem Einsatz in freier Konvektion und horizontaler Einbaulage mit nach oben gerichteten Rippen kann nur von beiden Stirnseiten Luft einströmen. Dies führt zu einer Reduzierung der Kühlleistung gegenüber vertikalem Einbau.

In Kenntnis dieses Standes der Technik hat sich der Erfinder das Ziel gesetzt, einen Kühlkörpertyp mit großer Oberfläche zu schaffen, durch den bereits bei relativ geringer Luftgeschwindigkeit eine Verwirbelung der Luft erreicht wird sowie ein Anströmen aus verschiedenen Richtungen und horizontaler Einbaulage bei freier Konvektion nicht zu drastischen Leistungseinbußen führt.

Zur Lösung dieser Aufgabe führt die Lehre des unabhängigen Patentanspruches; die Unteransprüche geben günstige Weiterbildungen an.

Erfindungsgemäß sind in die Kühlrippen jeweils mehrere Durchbrüche eingeformt, wobei die Flächen des zwischen zwei Stegen verlaufenden Durchbruches etwas geringer ist als der durch den lichten Rippenabstand vorgegebene Strömungsquerschnitt zwischen zwei benachbarten Kühlrippen.

Die eingesetzten Kühlrippen stabförmigen Querschnitts werden also so mit den Durchbrüchen versehen, daß -- in Längsrichtung betrachtet -- eine nahezu zaunförmige Anordnung entsteht. Diese quer zur Strömungsrichtung liegenden Durchbrüche lösen bereits bei relativ niedrigen Luftgeschwindigkeiten Verwirbelungen aus und führen damit zu einer Erhöhung des Wärmeübergangskoeffizienten.

Die Form des Durchbruches ist vorzugsweise so zu wählen, daß dessen Weite etwa gleich dem lichten Rippenabstand ist und/oder die zwischen den Durchbrüchen verbleibende Stegbreite in etwa gleich der Rippendicke. Damit wird eine Oberfläche erreicht wie bei einer nicht durchbrochenen Kühlrippe.

Als günstig hat es sich erwiesen, den Durchbruch schlitzartig zu gestalten sowie ihn sich vertikal fast über die gesamte freie Höhe der Kühlrippe erstrecken zu lassen, wobei in der Höhe an ihn zumindest eine volle Materialfläche anschließt.

Auch liegen im Rahmen der Erfindung mehrere Durchbrüche in einer Reihe übereinander, wobei zwischen den Reihen Stegbereiche verlaufen, die vorstehenden Maßgaben entsprechen.

So gibt es vertikale Reihen jeweils aus mehreren quadratischen oder rechteckigen Durchbrüchen, aber auch Reihen aus mehreren Bohrungen eines die Breite der Reihe bestimmenden Durchmessers.

Aus der DE-PS 35 18 310 sind tannenbaumähnliche -- also mit seitlich angeformten Kragrippen versehene -- Rippenprofile bekannt. Da diese den Einsatz der erfindungsgemäßen Maßgaben verhindern würden, können statt solcher Rippenprofile zur Erhöhung der Oberfläche Kühlrippen mit Längsnuten versehen sein, wenn die Breite der zwischen ihnen vorhandenen Ausformungen das Mehrfache der Nutentiefe messen. Die beim Stanzen nicht zu vermeidende Gratbildung am Nutenboden ist zur Wirbelbildung erwünscht.

Als günstig hat es sich erwiesen, die Kühlrippen je nach bevorzugter Anströmrichtung so einzusetzen, daß entweder die Durchbrüche und die Stege jeweils auf einer Querachse liegen oder aber Durchbruch und Steg auf einer Querachse wechselweise. Denn bei einer erfindungsgemäßen Ausgestaltung fluchten die Durchbrüche bzw. Reihen von Durchbrüchen einer Kühlrippe mit den Durchbrüchen bzw. Reihen von Durchbrüchen der benachbarten Kühlrippe/n. Bei einer anderen Form des Kühlkörpers jedoch fluchten die Stege einer Kühlrippe mit den Durchbrüchen bzw. den Reihen von Durchbrüchen der benachbarten Kühlrippe/n.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt in
- Fig. 1:: eine Schrägsicht auf einen Kühlkörper mit von einer Grundplatte aufragenden parallelen Kühlrippen;
- Fig. 2:: eine teilweise Stirnansicht des Kühlkörpers;
- Fig. 3:: ein Abschnitt einer Seitenansicht des Kühlkörpers der Fig. 1, 2;
- Fig. 4:: eine Seitenansicht einer Kühlrippe;
- Fig. 5:: den Schnitt durch Fig. 4 nach deren Linie V;
- Fig. 6:: die Stirnansicht einer anderen Kühlrippe;
- Fig. 7:: einen vergrößerten Ausschnitt aus Fig. 6;
- Fig. 8 bis Fig. 10:: Ausschnitte aus Seitenansichten unterschiedlicher Kühlrippen;
- Fig. 11:: den Schnitt durch den Kühlkörper der Fig. 2 nach deren Linie XI-XI;
- Fig. 12:: eine der Fig. 11 etwa entsprechende Wiedergabe eines anderen Kühlkörpers.

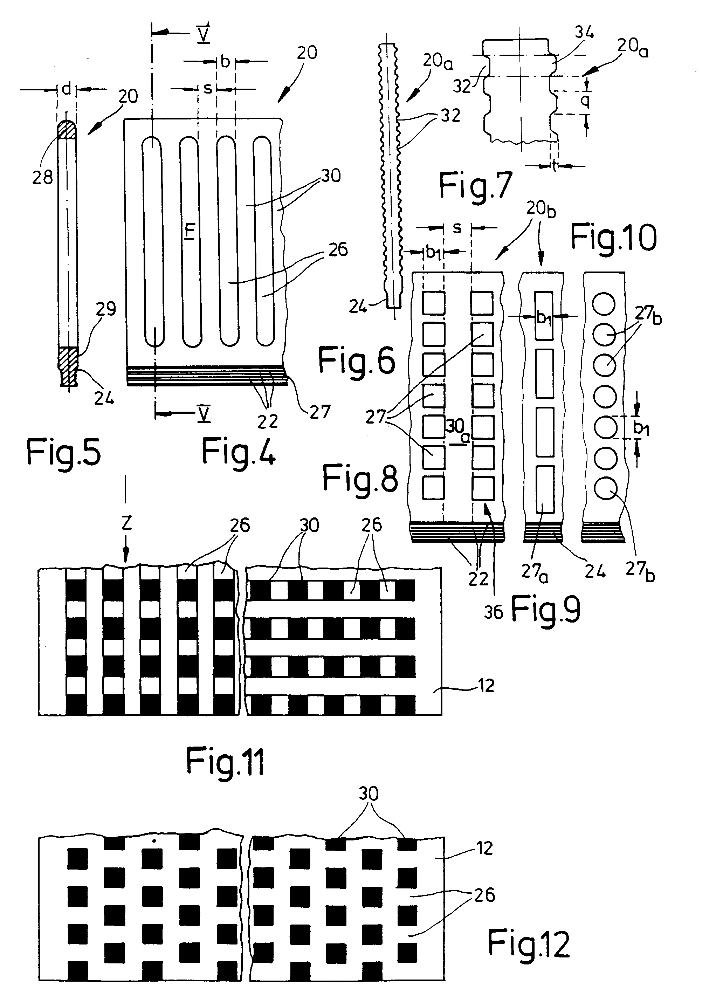

Ein querschnittlich kammartiger Kühlkörper 10 aus einer Aluminiumlegierung -- beispielsweise einer AlMgSi-Legierung -- für in der Zeichnung aus Gründen der Übersichtlichkeit nicht weiter dargestellte Halbleiterbauelemente weist eine Grundplatte 12 der Höhe h auf mit in deren Oberfläche 14 eingeformten Haltenuten 16, in die jeweils eine plattenartige Kühlrippe 20 der freien Höhe n mit einem gemäß Fig. 4, 5 längs verlaufende Sockelnuten 22 enthaltenden Stecksockel 24 eingesetzt ist. Insbesondere Fig. 2 läßt deutlich werden, daß die Grundplatte 12 getrennt von jenen Kühlrippen 20 hergestellt ist und zwar -- wie auch letztere -- auf dem Wege des Strangpressens.

Nach dem Strangpressen der Grundplatte 12 werden in deren Haltenuten 16 die Kühlrippen 20 mit ihren Stecksockeln 24 eingesetzt und darin durch plastisches Verformen der Nutenwände 17 festgelegt. Bei diesem Formvorgang bilden sich an der Nutenwand 17 Werkstoffwülste, welche in die Sockelnuten 22 der eingesetzten Kühlrippe 20 eingreifen.

In den zwischen jeweils zwei benachbarten Haltenuten 16 verbleibenden Streifen der Oberfläche 14 der Grundplatte 12 ist eine sogenannte Zwischennut 18 dreieckförmigen Querschnittes eingebracht, deren Tiefe geringer ist als jene der Haltenuten 16 und welche es erleichtert, die Nutenwand 17 in beschriebener Weise zu verformen. Nach diesem Einquetschen wird der so entstandene Kühlkörper 10 warm ausgehärtet.

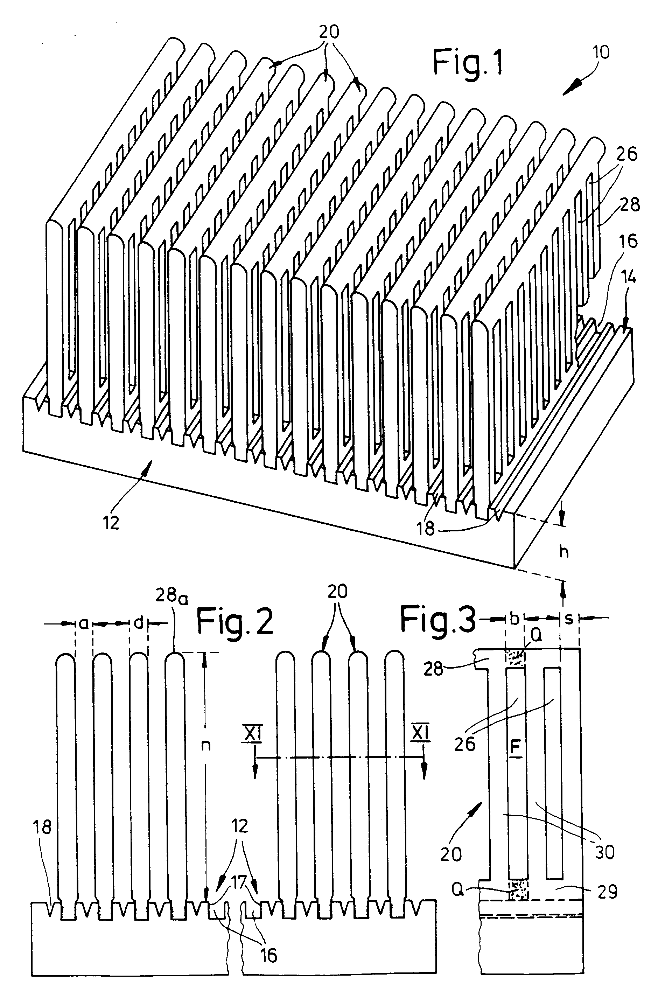

Jede der Kühlrippen 20 der Fig. 1 bis 5 ist mit schlitzartigen Durchbrüchen 26 versehen, die vertikal parallel gerichtet sowie von schmalen horizontalen Werkstoffstreifen 28, 29 und vertikalen Stegen 30 begrenzt sind. Dabei entspricht dem lichten Rippenabstand a zwischen parallel benachbarten -- eine querschnittlich gerundete Oberkante 28a aufweisenden -- Kühlrippen 20 die Weite b der Durchbrüche 26, der Dicke d der Kühlrippen 20 jedoch etwa die Breite s der Stege 30.

Der durch den Rippenabstand a bestimmte Strömungsquerschnitt zwischen zwei benachbarten Kühlrippen 20 ist also um das Maß der in Fig. 3 bei Q hervorgehobenen Flächen der den Durchbruch 26 oben und unten begrenzenden Abschnitte der Werkstoffstreifen 28, 29 -- d.h. geringfügig -- größer als die freie Fläche F des Durchbruches 26, der in den Fig. 1 bis 3 gestreckt rechteckig ausgebildet, in den Fig. 4, 5 aber entsprechend einem Langloch endwärts halbkreisförmig gerundet ist.

Die Kühlrippe 20a der Fig. 6 ist zudem mit in Preßrichtung -- also quer zur Bildebene -- verlaufenden, die Oberfläche vergrößernden Längsnuten 32 ausgestattet. Die Längsnuten 32 der einen Profiloberfläche können zu denen der anderen Profiloberfläche höhenversetzt sein; in Fig. 7 liegt querschnittlich jeweils einer Längsnut 32 der einen Oberfläche eine Längsrippe 34 der anderen Oberfläche gegenüber. Dabei mißt die Breite q der Längsrippen 34 etwa das Dreifache der Tiefe t der Längsnut 32.

Statt der schlitzartigen langen Durchbrüche 26 können gemäß Fig. 8 bis 10 bei Kühlrippen 20b in einer Vertikalreihe quadratische Durchbrüche 27, rechteckige Durchbrüche 27a oder kreisförmige Bohrungen 27b übereinander liegen. Die von den Durchbrüchen 27, 27a bzw. den Bohrungen 27b einer vertikalen Reihe -- 36 in Fig. 8 -- erzeugte freie Fläche zwischen den vertikalen Stegbereichen 30a entspricht etwa der Fläche F eines schlitzartigen Durchbruches 26; die Weite bl der kleineren Durchbrüche 27, 27a bzw. Bohrungen 27b kann etwas größer sein als die Weite b der schlitzartigen Durchbrüche 26.

Fig. 11 verdeutlicht eine Ausführungsform, bei der die Durchbrüche 26 -- und damit auch die Stege 30 -- sowohl in Anströmrichtung Z als auch quer dazu miteinander fluchten. In Fig. 12 sind die Durchbrüche 26 zueinander in beiden erwähnten Richtungen versetzt, d.h. der Steg 30 einer Kühlrippe 20 deckt den Durchbruch 26 bzw. die vertikale Reihe von Durchbrüchen 27, 27a bzw. Bohrungen 27b ab, die in Strömungsrichtung hinter ihm liegt. Erkennbar ist hier die etwa quadratische Form des von zwei Durchbrüchen 26, 27, 27a, 27b flankierten Stegquerschnitts.

## Patentansprüche

1. Kühlkörper für Halbleiterbauelemente od.dgl. Bauteil, insbesondere aus stranggepreßtem Leichtmetall, mit in Abstand etwa parallel zueinander von einer Grundplatte aufragenden Kühlrippen etwa stabartigen Querschnittes, wobei die Grundplatte an einer Oberfläche Haltenuten aufweist, in welchen jeweils eine Kühlrippe mit einem Sockelabschnitt festgelegt ist,
dadurch gekennzeichnet,
daß in die Kühlrippen (20, 20a, 20b) jeweils mehrere Durchbrüche (26, 27, 27a, 27b) eingeformt sind und die Flächen des zwischen zwei Stegen (30, 30a) verlaufenden Durchbruches etwas geringer ist als der durch den lichten Rippenabstand (a) vorgegebene Strömungsquerschnitt zwischen zwei benachbarten Kühlrippen.

2. Kühlkörper nach Anspruch 1, dadurch gekennzeichnet, daß die Weite (b, b1) des Durchbruches (26, 27, 27a, 27b) etwa dem lichten Rippenabstand (a) entspricht.

3. Kühlkörper nach Anspruch 1 oder 2, dadurch gekennzeichnet, daß die Breite (s) des Steges (30, 30a) etwa der Dicke (d) der Kühlrippe (20, 20a, 20b) entspricht.

4. Kühlkörper nach einem der Ansprüche 1 bis 3, dadurch gekennzeichnet, daß der Durchbruch (26) schlitzartig ausgebildet ist und sich vertikal über die freie Höhe (n) der Kühlrippe (20, 20a) erstreckt, wobei in dieser Höhe an ihn zumindest eine Materialfläche (Q) anschließt.

5. Kühlkörper nach einem der Ansprüche 1 bis 3, dadurch gekennzeichnet, daß mehrere Durchbrüche (27, 27a, 27b) in einer Reihe (36) übereinander angeordnet und von zwei Stegen (30a) begrenzt sind.

6. Kühlkörper nach Anspruch 5, gekennzeichnet durch vertikale Reihen (36) aus mehreren quadratischen oder rechteckigen Durchbrüchen (27, 27a).

7. Kühlkörper nach Anspruch 5, gekennzeichnet durch vertikale Reihen (36) aus mehreren Bohrungen (27b) eines die Breite der Reihe bestimmenden Durchmessers (b1).

8. Kühlkörper mit zur Grundplatte parallelen leistenartigen Ausformungen, die gegebenenfalls an den gegenüberliegenden Flächen der Kühlrippe zueinander höhenversetzt verlaufen nach einem der Ansprüche 1 bis 7, dadurch gekennzeichnet, daß die Breite (q) der Ausformungen (34) das Mehrfache der Tiefe (t) von dazwischen angeordneten Längsnuten (32) mißt.

9. Kühlkörper nach wenigstens einem der Ansprüche 1 bis 8, dadurch gekennzeichnet, daß die Durchbrüche (26) bzw. Reihen (36) von Durchbrüchen (27, 27a, 27b) einer Kühlrippe (20, 20a, 20b) mit den Durchbrüchen bzw. Reihen von Durchbrüchen der benachbarten Kühlrippe/n fluchten.

10. Kühlkörper nach wenigstens einem der Ansprüche 1 bis 8, dadurch gekennzeichnet, daß die Stege (30, 30a) einer Kühlrippe (20, 20a, 20b) mit den Durchbrüchen (26) bzw. den Reihen (36) von Durchbrüchen (27, 27a, 27b) der benachbarten Kühlrippe/n fluchten.
